# EUROPÄISCHE PATENTANMELDUNG

(11) **EP 1 507 132 A1**
(43) Veröffentlichungstag der Anmeldung: **16.02.2005**
(21) Anmeldenummer: 04018649.6
(22) Anmeldetag: 06.08.2004
(51) Int. Cl.: G01D 5/30, H03K 17/96

(54) **Verfahren sowie Schaltungsanordnung zur Ermittlung des Betätigungszustandes mindestens eines optischen Sensorelements**

(30) Priorität: 13.08.2003 DE 10337743
(71) Anmelder: E.G.O. ELEKTRO-GERÄTEBAU GmbH, D-75038 Oberderdingen (DE)
(72) Erfinder: Baier, Martin, 76275 Ettlingen (DE); Jungbauer, Markus, 76646 Bruchsal (DE)
(74) Vertreter: Patentanwälte Ruff, Wilhelm, Beier, Dauster & Partner

(57) **Zusammenfassung**

Die Erfindung betrifft ein Verfahren zur Ermittlung des Betätigungszustandes mindestens eines optischen Sensorelements (OS) sowie eine zugehörige Schaltungsanordnung. Erfindungsgemäß wird eine erste, am optischen Sensorelement (OS) anstehenden Lichtintensität abgespeichert, eine Lichtquelle (IL) eingeschaltet, eine zweite, am optischen Sensorelement (OS) anstehende Lichtintensität gemessen, die erste Lichtintensität von der zweiten Lichtintensität zur Bildung einer Lichtintensitätsdifferenz subtrahiert und die Lichtintensitätsdifferenz zur Ermittlung des Betätigungszustands bewertet. Eine erfindungsgemäße Schaltungsanordnung umfasst einen ansteuerbaren Analogwertspeicher (AWS), eine Ansteuereinheit (MC) zur Ansteuerung des Analogwertspeichers (AWS) und der Lichtquelle (IL), eine Subtraktionseinheit (SE) und eine Auswerteeinheit (MC), die das Ausgangssignal der Subtraktionseinheit (SE) bewertet, um den Betätigungszustand des Sensorelements (OS) zu ermitteln.

## Beschreibung

### Anwendungsgebiet und Stand der Technik

Die Erfindung betrifft ein Verfahren zur Ermittlung des Betätigungszustandes mindestens eines optischen Sensorelements nach dem Oberbegriff des Anspruchs 1 sowie eine zugehörige Schaltungsanordnung nach dem Oberbegriff des Anspruchs 4.

Tasten bzw. Betätigungselemente, deren Betätigungszustand optisch erfasst wird, beinhalten in der Regel eine Lichtquelle und ein optisches Sensorelement. Das von der Lichtquelle emittierte Licht wird bei Betätigung, beispielsweise an einem Finger, reflektiert, wodurch die Lichtintensität am optischen Sensorelement zunimmt. Überschreitet die Lichtintensität eine gewisse Schwelle, kann auf eine Betätigung des optischen Betätigungselements geschlossen werden.

In der Praxis erschweren jedoch einige Störgrößen eine zuverlässige Auswertung des Betätigungszustands des optischen Betätigungselements. So setzt sich das am optischen Sensor gemessene Signal aus mehreren Komponenten zusammen, die stark von Umgebungsbedingungen, beispielsweise einer Verschmutzung des Betätigungselements, abhängig sein können und somit die Auswertung wesentlich erschweren.

Eine erste Komponente ist hierbei das Umgebungslicht, das unabhängig davon, ob die Lichtquelle ein- bzw. ausgeschaltet ist, am optischen Sensor anliegt. Umgebungslichtquellen sind beispielsweise Sonnenlicht oder eine künstliche Beleuchtung durch Leuchtstoffröhren oder Glühlampen. Die Intensität des Umgebungslichts ist hierbei eine nicht kalkulierbare Störgröße und lässt sich nur schwer bzw. überhaupt nicht beeinflussen.

Bei eingeschalteter Lichtquelle ergeben sich weiterhin eine reflektierte und eine gestreute Komponente. Die reflektierte Komponente, die das Nutzsignal erzeugt, ist das durch die Betätigung hervorgerufene, reflektierte Licht. Die gestreute Komponente bzw. der Streulichtanteil ist derjenige Teil, der auf den optischen Empfänger gelangt, ohne aufgrund der Betätigung reflektiert zu werden.

Der optische Empfänger kann nicht zwischen Umgebungslicht und reflektiertem Licht unterscheiden. Der Anteil des reflektierten Lichts ist im Allgemeinen wesentlich geringer als der des Umgebungslichts. Für eine bessere Auswertung des reflektierten Lichtes müsste das Gesamtsignal des optischen Empfängers verstärkt werden. Durch den großen Anteil des Umgebungslichts kann jedoch kein großer Verstärkungsfaktor gewählt werden, da der Verstärker sonst in seine Begrenzung kommt. Dies erschwert die Auswertung erheblich.

Bekannte Problemlösungen sind der Einsatz von logarithmischen Verstärkern oder die Subtraktion einer Spannung von dem am optischen Sensorelement anliegenden Signal, die statisch derart gewählt wird, dass sie in etwa dem erwarteten Anteil an Umgebungslicht entspricht.

### Aufgabe und Lösung

Der Erfindung liegt als technisches Problem die Bereitstellung eines Verfahrens zur Ermittlung des Betätigungszustandes mindestens eines optischen Sensorelements sowie einer zugehörigen Schaltungsanordnung der eingangs genannten Art zugrunde, die mit geringem Aufwand zu realisieren sind, eine hohe Betriebssicherheit gewährleisten sowie weitgehend unabhängig von Umgebungs- und Einbaubedingungen sind.

Die Erfindung löst dieses Problem durch ein Verfahren mit den Merkmalen des Anspruchs 1 und eine Schaltungsanordnung mit den Merkmalen des Anspruchs 4. Vorteilhafte sowie bevorzugte Ausgestaltungen der Erfindung sind Gegenstand der weiteren Ansprüche und werden im folgenden näher erläutert. Der Wortlaut der Ansprüche wird durch ausdrückliche Bezugnahme zum Inhalt der Beschreibung gemacht. Merkmale, die für Verfahren und Vorrichtung gleichermaßen gelten, werden zum Teil nur einmal beschrieben, treffen jedoch für beide unabhängig voneinander zu.

Erfindungsgemäß wird eine erste, am optischen Sensorelement anstehenden Lichtintensität bei ausgeschalteter Lichtquelle gemessen und abgespeichert. Die Lichtintensität kann beispielsweise in Form einer zur Lichtintensität gehörigen Spannung gespeichert werden. Die abgespeicherte, erste Lichtintensität dient zur Bestimmung eines Messsignal-Offsets bei ausgeschalteter Lichtquelle, der im wesentlichen unabhängig vom Betätigungszustand des Betätigungselements ist. Insbesondere bildet sie die Lichtintensität des Umgebungslichts ab. Anschließend wird die Lichtquelle eingeschaltet und die resultierende, am optischen Sensorelement anstehenden Lichtintensität gemessen. Die derart gemessene Lichtintensität setzt sich aus Umgebungslicht, Streulicht und, falls das Betätigungselement betätigt ist, aus reflektiertem Licht zusammen. Anschließend wird die erste Lichtintensität von der zweiten Lichtintensität zur Bildung einer Lichtintensitätsdifferenz subtrahiert. Aufgrund dieser Subtraktion kann ein vorgegebener Dynamikbereich einer Auswerteschaltung gut ausgenutzt werden, da die erste Lichtintensität, die in der Regel nur einen vom Betätigungszustand im wesentlichen unabhängigen Offset des Sensorsignals darstellt, unterdrückt wird. Weiterhin wird eine Veränderung der Intensität des Umgebungslichts, die tageszeitlich oder durch Ein- bzw. Ausschalten einer Beleuchtung bedingt sein kann, kompensiert. Die Lichtintensitätsdifferenz wird in einem letzten Verfahrensschritt zur Ermittlung des Betätigungszustands ausgewertet. Üblicherweise erfolgt dies mit Hilfe eines oder mehrerer Schwellwerte, gegebenenfalls unter Einbeziehung einer Hysterese. Beispielsweise kann bei Überschreiten eines Schwellwertes der Betätigungszustand vereinbarungsgemäß auf "betätigt" gesetzt und bei Unterschreiten des Schwellwertes entsprechend auf "nicht betätigt" gesetzt werden. Die dargestellten Schritte werden zur fortlaufenden Ermittlung des Betätigungszustands mit einer einstellbaren Zykluszeit wiederholt. Mit Hilfe des dargestellten Verfahrens ist eine hohe Betriebssicherheit bei der Bestimmung des Betätigungszustandes gewährleistet und die Auswertung ist weitgehend unabhängig von Umgebungs- und Einbaubedingungen.

In einer Weiterbildung des Verfahrens wird die Lichtintensitätsdifferenz vor der Bewertung verstärkt, wodurch auch kleinere Signalhübe aufgrund einer Betätigung erkannt werden können. Ein zugehöriger Verstärkungsfaktor kann aufgrund der Unterdrückung der Intensität des Umgebungslichts vergleichsweise groß gewählt werden.

In einer Weiterbildung des Verfahrens werden die Betätigungszustände mehrerer optischer Sensorelemente in einem Multiplexbetriebszustand ermittelt. Dies ermöglicht die kostengünstige Auswertung des Betätigungszustands mehrerer optischer Sensorelemente, da eine Auswerte- bzw. Verstärkerschaltung nur einfach vorhanden zu sein braucht.

Eine Schaltungsanordnung zur Ermittlung des Betätigungszustandes mindestens eines optischen Sensorelements weist erfindungsgemäß einen ansteuerbaren Analogwertspeicher sowie eine Ansteuereinheit zur Ansteuerung des Analogwertspeichers und einer Lichtquelle auf. Die Ansteuereinheit steuert bei ausgeschalteter Lichtquelle den Analogwertspeicher derart an, dass dieser das am optischen Sensorelement anstehende Signal abspeichert. Der Analogwertspeicher enthält folglich ein der Umgebungslichtintensität entsprechendes Signal, beispielsweise in Form eines analogen Spannungswerts. Weiterhin umfasst die Schaltungsanordnung eine Subtraktionseinheit, die das im Analogwertspeicher abgespeicherte Signal von einem Sensorsignal subtrahiert, das bei eingeschalteter Lichtquelle am optischen Sensorelement ansteht. Die Subtraktionseinheit in Verbindung mit dem Analogwertspeicher ermöglicht die Unterdrückung von Signalen, die vom Umgebungslicht hervorgerufen werden. D.h. am Ausgang der Subtraktionseinheit stehen im wesentlichen Signalanteile an, die vom reflektierten Licht und vom Streulicht hervorgerufen werden. Eine ebenfalls in der Schaltungsanordnung enthaltene Auswerteeinheit bewertet das Ausgangssignal der Subtraktionseinheit, um den Betätigungszustand des Sensorelements zu ermitteln.

In einer Weiterbildung der Schaltungsanordnung ist das optische Sensorelement ein Fototransistor. Fototransistoren weisen eine ausreichende Detektionsleistung auf, sind im Vergleich zu anderen optischen Sensorelementen, beispielsweise PIN-Dioden, kostengünstig beschaffbar und erfordern einen geringen Schaltungsaufwand. PIN-Dioden haben jedoch den Vorteil, dass ihre Reaktionsgeschwindigkeit auf Lichtintensitätsänderungen erheblich höher ist als die von Phototransistoren.

Somit wäre es möglich, die Tastenmessung so schnell zu machen, dass 50 bzw. 100Hz Störungen von Kunstlicht sich nicht mehr auswirken.

In einer Weiterbildung der Schaltungsanordnung umfasst die Lichtquelle mindestens eine Infrarot-Leuchtdiode. Das von der Infrarot-Leuchtdiode emittierte Licht liegt in einem Spektralbereich, der für den Menschen nicht sichtbar ist. Eine Störung eines Benutzers durch das von der Infrarot-Leuchtdiode emittierte Licht wird folglich vermieden.

In einer Weiterbildung der Schaltungsanordnung ist die Ansteuereinheit und/oder die Auswerteeinheit ein Mikroprozessor. Vorteilhaft ist hierbei die Subtraktionseinheit durch differentielle Eingänge eines in den Mikroprozessor integrierten A/D-Wandlers realisiert. Dies ermöglicht eine kostengünstige Kombination von Ansteuereinheit, Auswerteeinheit bzw. Subtrahierer, reduziert die Anzahl der benötigten Bauelemente und erhöht die Zuverlässigkeit der Schaltungsanordnung.

In einer Weiterbildung umfasst die Schaltungsanordnung einen Verstärker, der das Ausgangssignal der Subtraktionseinheit vor der Bewertung durch die Auswerteeinheit verstärkt. Vorteilhaft liegt der Verstärkungsfaktor des Verstärkers in einem Bereich von 2 bis 50, insbesondere in einem Bereich von 5 bis 10. Vorteilhaft ist der Verstärker in einen Mikroprozessor integrierten, der gleichzeitig als Ansteuereinheit und/oder als Auswerteeinheit dient.

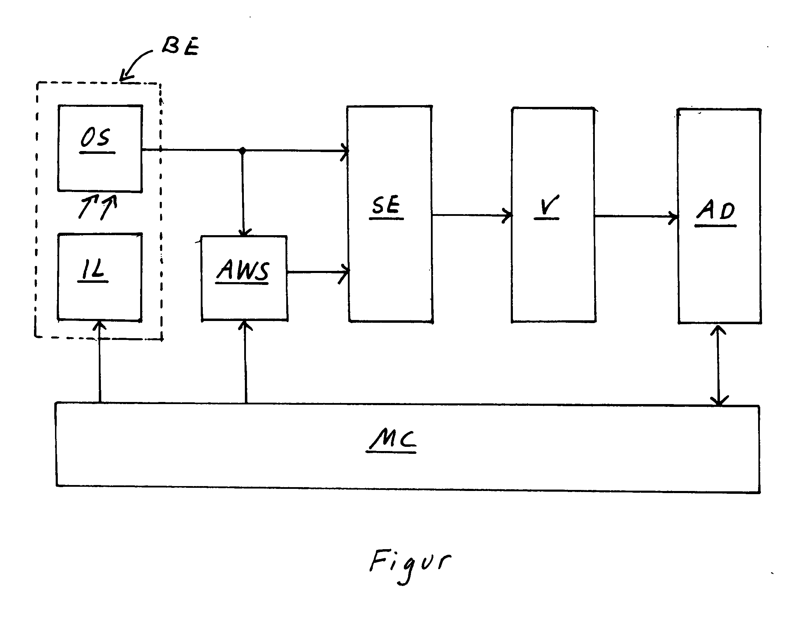

Diese und weitere Merkmale gehen außer aus den Ansprüchen auch aus der Beschreibung und der Zeichnung hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ein Ausführungsbeispiel der Erfindung ist in der Zeichnung schematisch dargestellt und wird nachfolgend beschrieben, wobei die einzige Figur ein Blockschaltbild einer Schaltungsanordnung zur Ermittlung des Betätigungszustandes mehrerer optischer Betätigungselemente zeigt.

### Detaillierte Beschreibung des Ausführungsbeispiels

Die Schaltungsanordnung umfasst hierzu optische Sensorelemente in Form von Fototransistoren, von denen aus Gründen der Einfachheit exemplarisch nur ein optisches Sensorelement OS gezeigt ist. Die nicht gezeigten Sensorelemente sind entsprechend beschaltet. Die Ansteuerung erfolgt in einem Multiplex-Betriebsverfahren.

Einem optischen Sensorelement OS ist jeweils eine Lichtquelle in Form einer Infrarot-Leuchtdiode IL zugeordnet. Das optische Sensorelement OS und die ihm zugeordnete Infrarot-Leuchtdiode IL bilden zusammen ein optisches Betätigungselement BE bzw. eine Taste. Die Infrarot-Leuchtdiode IL wird von einem Mikroprozessor MC ein- bzw. ausgeschaltet.

Das am optischen Sensor OS anstehende Signal wird einem Analogwertspeicher AWS zugeführt. Der Analogwertspeicher AWS wird vom Mikroprozessor MC angesteuert und übernimmt das am Sensor anstehende Signal bzw. die Spannung bei ausgeschalteter Infrarot-Leuchtdiode IL. Die gespeicherte Spannung bildet folglich die Lichtintensität des Umgebungslichts ab und dient zur Bestimmung eines Messsignal-Offsets bei ausgeschalteter Lichtquelle, der im wesentlichen unabhängig vom Betätigungszustand des Betätigungselements BE ist. Die im Analogwertspeicher gespeicherte Spannung wird einer Subtraktionseinheit SE zugeführt.

Anschließend wird die Infrarot-Leuchtdiode IL angeschaltet. Die sich am optischen Sensorelement OS einstellende Spannung wird ebenfalls der Subtraktionseinheit SE zugeführt. Diese bildet die Differenz aus der im Analogwertspeicher AWS gespeicherten Spannung und der am optischen Sensorelement anstehenden Spannung. Die Spannungsdifferenz ist ein Maß für die Summe aus reflektiertem und gestreutem Licht bei betätigtem Betätigungselement BE bzw. gestreutem Licht bei nicht betätigtem Betätigungselement BE. Der im Analogwertspeicher AWS gespeicherte Messsignal-Offset des Umgebungslichts, der im wesentlichen unabhängig vom Betätigungszustand des Betätigungselement BE ist, wird dadurch unterdrückt. Dies erleichtert eine Auswertung in nachfolgenden Schaltungsteilen, da das Differenzsignal, d.h. der sich aufgrund einer Betätigung ergebende Signalhub, deutlich höher verstärkt werden kann.

Das Ausgangssignal der Subtraktionseinheit SE wird durch einen Verstärker V mit einem Verstärkungsfaktor von ca. 7 verstärkt und einem A/D-Wandler AD zur Digitalisierung zugeführt. Das digitalisierte Ausgangssignal wird vom Mikroprozessor MC ausgelesen und zur Ermittlung des Betätigungszustands mit einem Schwellwert unter Einbeziehung einer Hysterese verglichen. Wenn der gemessene Wert den Schwellwert überschreitet, wird das Betätigungselement BE als betätigt erkannt. Bei Unterschreiten des Schwellwertes wird das Betätigungselement BE entsprechend als nicht betätigt erkannt. Die dargestellten Schritte werden zur fortlaufenden Ermittlung des Betätigungszustands mit einer einstellbaren Zykluszeit wiederholt.

Die Subtraktionseinheit SE, der Verstärker V sowie der A/D-Wandler AD können auch im Mikroprozessor MC enthalten sein. Vorzugsweise verfügt der Mikroprozessor MC über differentielle Eingänge. Das zwischen diesen differentiellen Eingängen anliegende Differenzsignal kann intern, beispielsweise um den Faktor 10, verstärkt werden. Die Auswertung des Differenzsignals erfolgt wie oben beschrieben.

Die oben beschriebene Ausführungsform zeigt ein Verfahren sowie eine zugehörige schaltungstechnische Umsetzung, die mit geringem Aufwand realisierbar sind, eine hohe Betriebssicherheit gewährleisten sowie weitgehend unabhängig von Umgebungs- und Einbaubedingungen sind.

## Patentansprüche

1. Verfahren zur Ermittlung des Betätigungszustandes mindestens eines optischen Sensorelements (OS), bei dem eine erste, am optischen Sensorelement (OS) anstehenden Lichtintensität gemessen wird,
**gekennzeichnet durch** die Schritte:
- Abspeichern der ersten, am optischen Sensorelement (OS) anstehenden Lichtintensität,
- Einschalten einer dem optischen Sensorelement (OS) zugeordneten Lichtquelle (IL),
- Messen einer zweiten, am optischen Sensorelement (OS) anstehenden Lichtintensität,
- Subtrahieren der ersten Lichtintensität von der zweiten Lichtintensität zur Bildung einer Lichtintensitätsdifferenz und
- Bewerten der Lichtintensitätsdifferenz zur Ermittlung des Betätigungszustands.

2. Verfahren nach Anspruch 1, **dadurch gekennzeichnet, dass** die Lichtintensitätsdifferenz vor der Bewertung, vorzugsweise mit einem Verstärkungsfaktor in einem Bereich von 2 bis 50, insbesondere in einem Bereich von 5 bis 10, verstärkt wird.

3. Verfahren nach Anspruch 1 oder 2, **dadurch gekennzeichnet, dass** die Betätigungszustände mehrerer optischer Sensorelemente in einem Multiplexbetriebszustand ermittelt werden.

4. Schaltungsanordnung zur Ermittlung des Betätigungszustandes mindestens eines optischen Sensorelements (OS), insbesondere zur Durchführung des Verfahrens nach einem der Ansprüche 1 bis 3, mit
- mindestens einem optischen Sensorelement (OS) zur Messung einer Lichtintensität und
- mindestens einer dem optischen Sensorelement (OS) zugeordneten Lichtquelle (IL),
**gekennzeichnet durch**
- einen ansteuerbaren Analogwertspeicher (AWS),
- eine Ansteuereinheit (MC) zur Ansteuerung des Analogwertspeichers (AWS) und der Lichtquelle (IL), die bei ausgeschalteter Lichtquelle (IL) den Analogwertspeicher (AWS) derart ansteuert, dass dieser das am optischen Sensorelement (OS) anstehende Signal abspeichert,
- eine Subtraktionseinheit (SE), die das im Analogwertspeicher (AWS) abgespeicherte Signal von einem Sensorsignal subtrahiert, das bei eingeschalteter Lichtquelle (IL) am optischen Sensorelement (OS) ansteht, und
- eine Auswerteeinheit (MC), die das Ausgangssignal der Subtraktionseinheit (SE) bewertet, um den Betätigungszustand des optischen Sensorelements (OS) zu ermitteln.

5. Schaltungsanordnung nach Anspruch 4, **dadurch gekennzeichnet, dass** das optische Sensorelement ein Fototransistor (OS) ist.

6. Schaltungsanordnung nach Anspruch 4 oder 5, **dadurch gekennzeichnet, dass** die Lichtquelle mindestens eine Infrarot-Leuchtdiode (IL) umfasst.

7. Schaltungsanordnung nach einem der Ansprüche 4 bis 6, **dadurch gekennzeichnet, dass** die Ansteuereinheit und/oder die Auswerteeinheit ein Mikroprozessor (MC) ist.

8. Schaltungsanordnung nach Anspruch 7, **dadurch gekennzeichnet, dass** die Subtraktionseinheit (SE) durch differentielle Eingänge eines in den Mikroprozessor (MC) integrierten A/D-Wandlers (AD) realisiert ist.

9. Schaltungsanordnung nach einem der Ansprüche 5 bis 8, **gekennzeichnet durch** einen Verstärker (V), der das Ausgangssignal der Subtraktionseinheit (SE) vor der Bewertung **durch** die Auswerteeinheit (MC) verstärkt, wobei vorzugsweise der Verstärkungsfaktor des Verstärkers (V) in einem Bereich von 2 bis 50 liegt, insbesondere in einem Bereich von 5 bis 10.

10. Schaltungsanordnung nach Anspruch 9, **dadurch gekennzeichnet, dass** der Verstärker (V) in einen Mikroprozessor (MC) integriert ist, der gleichzeitig als Ansteuereinheit und/oder als Auswerteeinheit dient.
